# FASCICULE DE BREVET EUROPEEN

(11) **EP 0 702 843 B1**
(45) Date de publication et mention de la délivrance du brevet: **02.01.2002**
(21) Numéro de dépôt: 95916710.7
(22) Date de dépôt: 05.04.1995
(51) Int. Cl.: H01J 27/18, H01J 37/317

(54) **IMPLANTEUR IONIQUE HAUTE ENERGIE DE TYPE FAIBLE OU MOYEN COURANT ET PROCEDE D'UTILISATION D'UN TEL IMPLANTEUR**
HOCHENERGIE-IONIMPLANTIERUNGSVORRICHTUNG VOM SCHWACH -ODER MITTELSTROMTYP UND VERWENDUNG EINER SOLCHEN VORRICHTUNG
DEVICE FOR HIGH ENERGY ION IMPLANTATION OF THE LOW OR MEDIUM CURRENT KIND AND METHOD FOR ITS USE

(30) Priorité: 06.04.1994 FR 9404027
(43) Date de publication de la demande: 27.03.1996
(73) Titulaire: FRANCE TELECOM, 75015 Paris (FR)
(72) Inventeur: GROUILLET, André, F-38000 Grenoble (FR)
(74) Mandataire: Casalonga, Axel
(86) Numéro de dépôt international: FR9500433
(87) Numéro de publication internationale: WO9527996

(56) Documents cités:
- EP-A- 0 527 082
- JOURNAL OF VACUUM SCIENCE AND TECHNOLOGY: PART A., vol.9, no.2, Mars/Avril 1991, NEW YORK US pages 307 - 311 K. AMEMIYA ET AL. 'Production of milliampere class mass-separated multiply charged ion beam.'
- PATENT ABSTRACTS OF JAPAN vol. 18, no. 252 (E-1547) 13 Mai 1994 & JP,A,06 036 735 (JAPAN STEEL WORKS LTD) 10 Février 1994

## Description

L'invention concerne l'implantation ionique faible ou moyen courant, notamment en microélectronique.

Les premières utilisations de l'implantation ionique haute énergie en microélectronique concernaient la fabrication de senseurs CCD (Charge Coupled Device en langue anglaise) et la programmation de mémoires mortes, par exemple pour les jeux électroniques.

L'implantation ionique haute énergie (de l'ordre de 600 à 700 keV d'ions phosphore dans le silicium) a depuis connu d'autres applications, par exemple pour améliorer l'isolement latéral dans les circuits CMOS à haute densité d'intégration.

L'implantation ionique haute énergie trouve également de nombreux avantages dans la fabrication de composants semiconducteurs. Elle permet ainsi d'effectuer un isolement de champ ("channel stopper") qui offre, outre un meilleur isolement latéral, une réduction de la distance n⁺/p⁺ entre transistors NMOS et PMOS et de la diffusion des dopants dans les zones actives du composant semi-conducteur pendant l'oxydation.

Un autre avantage réside dans la réalisation de collecteurs enterrés minces et localisés dans les technologies bipolaires. Une telle implantation ionique nécessite des doses de quelques 10¹⁴ ions de phosphore par cm² à une énergie de 1,5 MeV ou bien de bore à 800 keV.

On peut encore citer la réalisation de couches enterrées pour diminuer les courants de fuite par le substrat. Actuellement ces réalisations sont généralement effectuées par épitaxie, qui est une technique délicate et onéreuse en milieu industriel. Aussi est-il alors préférable d'effectuer des implantations ioniques à des doses 10¹⁵ ions par cm² de phosphore à 1,5 MeV ou bien de bore à 800 keV.

Or les énergies de l'ordre du MeV (mégaélectron-volt) nécessitent actuellement le recours à la solution coûteuse des accélérateurs classiques de type linéaire. De telles machines existent mais elles sont d'un prix très élevé et demeurent des machines de laboratoire, car les industriels leur reprochent leur manque de fiabilité et de souplesse et hésitent surtout à investir dans une machine ne permettant de satisfaire qu'un petit nombre d'étapes technologiques (une voire deux).

Afin que l'implantation haute énergie devienne une technique relativement abordable pour des industriels, une solution consiste à utiliser des ions multichargés. Cependant, les sources d'ions utilisées sont généralement des sources à filament chaud qui ont une durée de vie de fonctionnement d'une vingtaine d'heures environ et ne permettent en outre d'obtenir que de faibles courants disponibles conduisant à l'obtention de doses d'ions multichargés ne dépassant guère 10¹³/cm² (voir notamment l'article de A. GROUILLET et autres, "Device performances and parametric studies of high energy implantations with multiple charged ion beams"" ION IMPLANTATION TECHNOLOGY - 92, p. 417-420).

Il existe par ailleurs un autre type de source d'ions multichargés combinant à la fois deux forts champs magnétiques (l'un axial et l'autre radial) ainsi qu'une injection d'un champ électromagnétique hyperfréquence dans une chambre d'ionisation, dont les dimensions sont calculées pour que la source travaille en condition de résonance cyclotronique électronique, permettant l'obtention, à partir d'un gaz admis dans la chambre de ionisation, d'un plasma gazeux ionisé contenant des ions fortement chargés.

Ce type de source d'ions a été initialement mis au point pour être appliqué à la fusion nucléaire. On a pu ainsi obtenir des ions multichargés tels Ar¹³⁺, Kr²⁰⁺ ou Xe²⁰⁺. Cependant, de telles sources sont extrêmement lourdes et volumineuses, sans compter le volume du bloc d'alimentation qui leur est nécessaire, et, ces contraintes rendent leur adaptation à des implanteurs industriels classiques rigoureusement impossible.

On connaît certes par la demande de brevet européen n° 0 527 082 une source à résonance cyclotronique électronique (source ECR) de taille réduite. Néanmoins la source décrite dans ce document antérieur, associée à une alimentation hyperfréquence produisant l'énergie hyperfréquence nécessaire à la génération du plasma ionisé, ne peut pas être disposée dans un implanteur classique en raison notamment des contraintes de dimensionnement de l'ensemble source-alimentation hyperfréquence. En outre, le faisceau ionisé de sortie de la source décrite dans ce document antérieur présente des caractéristiques géométriques incompatibles avec la plupart des implanteurs industriels standard. Par ailleurs le diamètre usuel du faisceau de sortie d'une telle source ECR, typiquement de quelques millimètres, ainsi que l'utilisation de gaz simples tels que l'hydrogène, le néon, le xénon, l'argon, l'oxygène, le tungstène ou le titane, autorisent aisément l'emploi d'une telle source dans des applications de séparation isotropique mais rendent cette source inadaptable telle quelle pour des applications d'implantation d'ions multichargés dans le domaine de la microélectronique et en outre inutilisable telle quelle dans les implanteurs industriels standard.

L'invention a pour but d'augmenter l'énergie d'implantation d'un implanteur industriel classique du type faible ou moyen courant, dont l'énergie maximale d'implantation ne dépasse pas quelques centaines de keV, typiquement 200 à 250keV, pour obtenir des énergies de l'ordre du MeV, tout en permettant d'atteindre des doses d'ions pouvant aller jusqu'à 10¹⁴/cm² voire plus, et ce de façon simple à un coût industriellement acceptable.

Au sens de la présente invention, un implanteur de type faible ou moyen courant est un implanteur dont l'intensité du courant de faisceau total mesurée en aval de l'accélérateur est inférieur à environ 5 mA.

L'invention a aussi pour but de faire fonctionner un tel implanteur ionique classique avec une source d'ions à résonance cyclotronique électronique, alors qu'aucun de tels implanteurs n'est équipé initialement d'un tel type de source. En effet les sources d'ions classiquement utilisées dans ce type d'implanteurs sont généralement des sources à filament chaud ou à cathode froide.

L'invention permet le remplacement des sources classiques par exemple à filament chaud, existant dans de tels implanteurs par une source d'ions à résonance cyclotronique électronique équipée de son alimentation hyperfréquence tout en respectant les contraintes d'encombrement de ces implanteurs existants.

Une telle source à résonance cyclotronique électronique peut être adaptée à la plupart des implanteurs industriels de type faible ou moyen courant.

L'invention permet aussi d'obtenir des faisceaux d'ions multichargés particulièrement stables avec des courants de balayage de quelques dizaines de micro-ampères, notamment avec des ions phosphore P⁴⁺, P⁵⁺ et P⁶⁺.

Telle que revendiquée, l'invention propose un implanteur ionique du type faible ou moyen courant. Selon l'invention, l'implanteur ionique loge une source d'ions multichargés à résonance cyclotronique électronique comportant une cavité de plasma formant guide d'ondes capable de recevoir un milieu gazeux complexe compatible avec le faisceau ionisé généré, et un générateur hyperfréquence à tube à ondes progressives couplé à ladite source et générant un champ électromagnétique de fréquence supérieure ou égale à 6 GHz, la cavité de plasma ayant une dimension caractéristique, dans le plan transversal de la cavité, du même ordre de grandeur que la longueur d'onde du champ électromagnétique. La source est munie au niveau de son extrémité de sortie d'une optique ionique de réglage des caractéristiques géométriques du faisceau de plasma ionisé extrait de la cavité, ladite optique ionique étant commandable et coopérant avec l'électrode d'extraction de la source d'ions formée d'un cône s'évasant vers la sortie de la source. Et la source est munie au niveau de son extrémité d'entrée de moyens d'admission du milieu gazeux permettant un maintien d'une pression résiduelle de vide en fonctionnement inférieure à un seuil de pression compatible avec l'obtention d'ions multichargés.

D'une façon générale, le générateur hyperfréquence est choisi de façon à avoir un encombrement réduit, typiquement inférieur à 50 dm³, pour pouvoir être logé à l'intérieur de l'implanteur et avantageusement à l'intérieur de la carcasse du bloc d'alimentation de la source d'ions initiale de l'implanteur. La fonction du générateur hyperfréquence à tube à ondes progressives utilisé ici est donc double. En effet, ce type de générateur, connu pour ses applications dans le domaine des radars, permet d'une part de générer le champ électromagnétique de fréquence souhaitée et d'autre part une insertion aisée dans l'implanteur, et notamment dans la carcasse du bloc d'alimentation de la source initiale, en raison de son encombrement réduit.

Le milieu gazeux complexe est avantageusement choisi dans le groupe formé par les gaz de formulation chimique PH₃, B₂H₆, A_{S}H₃, PF₅, A_{S}F₅, BF₃, PCl₅, A_{S}Cl₃, BCl₃ et plus généralement les hydrures, les fluorures, les chlorures des dopants compatibles avec la nature d'un matériau semi-conducteur à implanter.

On règle avantageusement le débit d'admission du milieu gazeux complexe dans la cavité de plasma de façon à maintenir dans ladite cavité une pression inférieure à 10⁻⁶ Torr et de préférence de quelques 10⁻⁷ Torr ce qui permet d'obtenir un faisceau stable d'ions fortement chargés, notamment des ions phosphores P⁴⁺, P⁵⁺, P⁶⁺.

Selon un mode de réalisation de l'invention, l'optique ionique de réglage comporte une première électrode plane perforée obturant la face évasée du cône d'extraction, une deuxième électrode plane perforée espacée de la première, et portée au même potentiel, typiquement à la masse, que celui du cône d'extraction et de la première électrode, et une électrode centrale, plane et perforée, disposée entre les première et deuxième électrodes et polarisée par rapport à ces deux électrodes par une tension de polarisation réglable.

Selon un mode de réalisation de l'invention, l'optique ionique est fixée à la source par un premier isolateur électrique tandis que la source est solidaire d'une bride de fixation équipée d'un deuxième isolateur électrique, la bride de fixation étant destinée à être fixée par l'intermédiaire de ce deuxième isolateur électrique sur l'implanteur ionique.

Le générateur hyperfréquence forme avantageusement un module d'alimentation hyperfréquence, séparé de la source équipée de sa bride de fixation et de l'optique ionique de réglage; ce module d'alimentation hyperfréquence a un volume utile inférieur à 50 dm³ et comporte le tube à ondes progressives relié à un oscillateur par l'intermédiaire d'un atténuateur variable, ainsi que les blocs d'alimentation de ces éléments. Le module d'alimentation hyperfréquence est alors couplé à la cavité de plasma de la source par un guide d'ondes.

L'invention a également pour objet un procédé d'utilisation d'un tel implanteur dans lequel on admet dans la cavité de plasma le milieu gazeux complexe compatible avec le faisceau d'ions souhaités, on règle le débit d'admission du milieu gazeux de façon à maintenir dans la cavité de plasma un vide résiduel inférieur audit seuil de pression, et on règle la focalisation du faisceau ionique extrait de la cavité de plasma, au point focal de l'aimant d'analyse de l'implanteur.

On peut régler la focalisation du faisceau ionique extrait de la cavité de plasma au point focal objet de l'aimant d'analyse de l'implanteur en réglant la tension d'alimentation de l'optique ionique de réglage de la source.

D'autres avantages et caractéristiques de l'invention apparaîtront à l'examen d'un mode de réalisation nullement limitatif, et des dessins annexés sur lesquels :
- la figure 1 illustre schématiquement la structure d'un implanteur ionique de l'art antérieur,
- la figure 2 illustre un mode de réalisation d'une source d'ions multichargés à résonance cyclotronique électronique selon l'invention, et
- la figure 3 illustre schématiquement les constituants principaux du module d'alimentation hyperfréquence de la source de la figure 2.

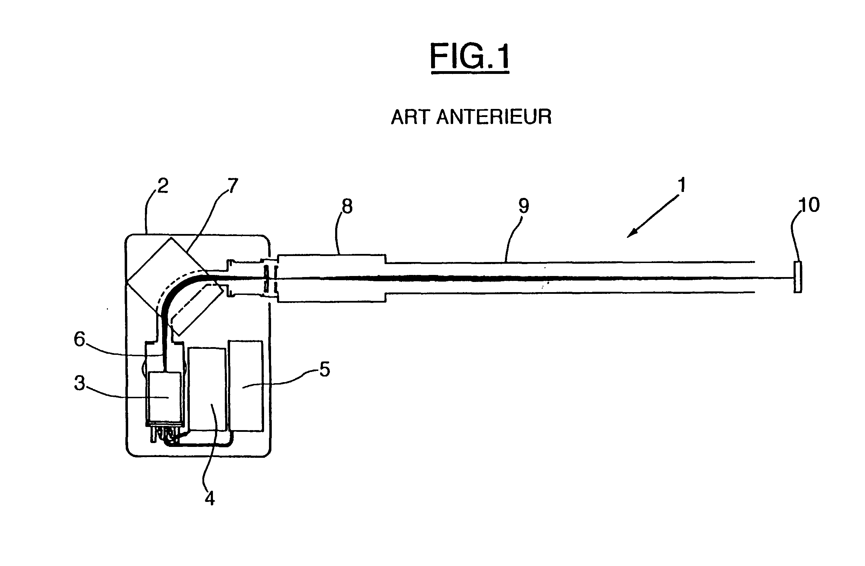

Les implanteurs industriels classiques, permettant des implantations ioniques à 200 voire 250 keV, ont une structure analogue à celle représentée schématiquement sur la figure 1. Plus précisément, un tel implanteur 1 comporte, à l'intérieur d'une enceinte haute tension 2, une source d'ions 3 généralement à filament chaud ou à cathode froide, reliée à un bloc d'alimentation électrique 4 ainsi qu'à un réservoir 5 de gaz susceptible d'être ionisé par les électrons émis, depuis la cathode alimentée électriquement, vers une anode polarisée.

La source d'ions 3 produit un faisceau ionisé 6 en direction d'un aimant d'analyse 7 dont la fonction est d'effectuer un tri des ions en fonction de leur rapport masse/charge de façon à obtenir en sortie les ions effectivement souhaités pour l'implantation ionique de la plaquette 10. Le faisceau issu de l'aimant d'analyse 7 est ensuite accéléré dans un tube d'accélération 8 qui confère l'énergie requise pour l'implantation (200 à 250 keV). Le reste de l'implanteur est schématisé par un tube 9 comportant notamment des pompes à vide, et des moyens destinés à diriger le faisceau d'ions vers la plaquette 10.

On distingue parmi les types d'implanteurs industriels ceux à faible courant, à moyen courant et à fort courant. Par "courant" il faut entendre ici le courant du faisceau total mesuré juste en aval du tube accélérateur 8. Un implanteur est du type à moyen courant lorsque le courant de faisceau total est compris entre environ 100 µA et environ 5 mA. Il est à faible courant lorsque le courant de faisceau total est inférieur à 100 µA.

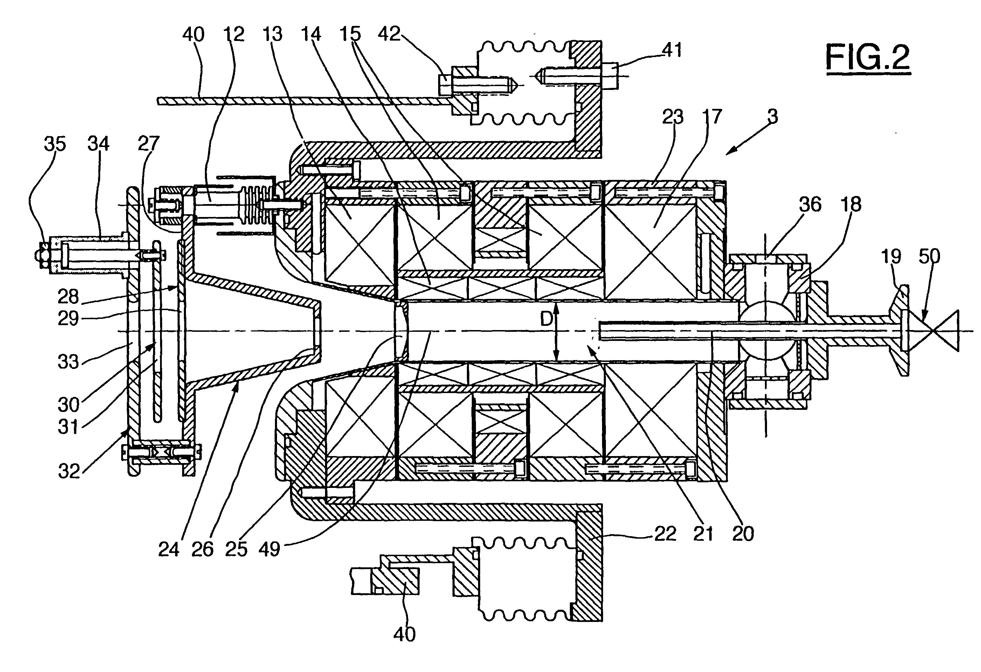

L'un des moyens de l'invention consiste en une source d'ions multichargés à résonance cyclotronique électronique (source ECR) qui pourra notamment être insérée dans un implanteur du type de celui illustré sur la figure 1 en lieu et place de la source classique dont est équipé l'implanteur. Un exemple de réalisation d'une telle source ECR selon l'invention est illustré sur la figure 2.

La source d'ions multichargés selon l'invention permet, en combinaison avec un générateur hyperfréquence de taille réduite, d'être disposée à l'intérieur d'un implanteur industriel standard sans modifier profondément les autres éléments de l'enceinte haute tension de cet implanteur.

La source 3 selon l'invention, comporte, à l'intérieur d'une carcasse 23 équipée solidairement d'une bride de fixation 22, une cavité de plasma 21 formant un guide d'onde ayant une dimension caractéristique D. Cette dimension caractéristique est une dimension comptée dans le plan transversal, c'est-à-dire perpendiculaire à l'axe longitudinal de symétrie 42 de la source, et est en fait dans le cas présent le diamètre D du guide d'onde 21.

A son extrémité droite sur la figure, la source comporte une cavité de transition 18 entre la cavité de plasma 21 et l'ouverture 36 sur laquelle est fixé par l'intermédiaire de moyens d'accord hyperfréquence, un guide d'ondes (ces deux moyens ne sont pas représentés à des fins de simplification) reliant la cavité de plasma au générateur hyperfréquence.

La dimension caractéristique D de la cavité de plasma est du même ordre de grandeur que la longueur d'onde du champ électromagnétique injecté dans ladite cavité. Par "même ordre de grandeur", on entendu ici un rapport D/λ (où λ désigne la longueur d'onde du champ électromagnétique) compris entre environ 0,5 et environ 1,5. Par ailleurs, le champ électromagnétique hyperfréquence est généré à une fréquence au moins égale à 6 GHz, typiquement 10 GHz. La combinaison de ces deux caractéristiques conduit à l'obtention d'une cavité de plasma de diamètre réduit, typiquement de l'ordre de 26 mm pour une fréquence de 10 GHz. Par conséquent, le faible diamètre de cette cavité de plasma permet d'obtenir un faible diamètre extérieur hors tout de la bride de fixation de la source, typiquement 40 cm, rendant aisément possible la disposition de cette source 3 en lieu et place de la source classique 3 d'un implanteur industriel standard.

La cavité de plasma 21, dont la longueur est typiquement de l'ordre de 100 mm, est entourée d'aimants permanents juxtaposés, avantageusement fortement coercitifs en raison de la petite taille de la source d'ions. Ces aimants comportent tout d'abord un aimant d'injection 17, à aimantation radiale, situé au niveau de l'extrémité de sortie du tube coaxial 20 d'injection du milieu gazeux dans la cavité 21. La paroi de la cavité 21 est ensuite entourée d'un système d'aimants octopolaires à aimantation radiale 14 définissant dans la cavité de plasma 21 un champ magnétique radial de confinement. Autour de ce système d'aimants 14 est prévu un autre système d'aimants permanents 15 à aimantation axiale contribuant à la création d'un champ magnétique à symétrie axiale. Enfin, il est prévu de disposer, autour de la cavité 21, entre l'électrode de plasma 25 et l'électrode d'extraction 24 un aimant d'extraction à aimantation radiale 13 formant avec l'aimant d'injection 17 deux miroirs magnétiques. La résonance cyclotronique est obtenue par l'action conjuguée d'un champ électromagnétique hyperfréquence injecté dans la cavité et du champ magnétique à symétrie axiale dont la valeur de l'induction est minimum dans le plan médian transversal de la cavité.

La bride de fixation 22 de la source d'ions est fixée sur un châssis 40 de l'implanteur par l'intermédiaire d'un isolant électrique 16 et de vis de fixation 41 et 42. L'isolant 16 est choisi de façon à supporter une très haute différence de potentiel, typiquement 20 kV, existant d'une part, entre la bride de fixation 22 reliée à la tension d'alimentation de la source, typiquement 20 kV, par l'intermédiaire par exemple d'un câble électrique fixé au niveau de la vis 41, et d'autre part le châssis 40 de l'implanteur, mis à la masse.

L'électrode de plasma 25 est donc également portée au potentiel de 20 kV tandis que l'électrode d'extraction 24 est portée à la masse ce qui permet d'accélérer les ions formés dans la cavité 21. Il est donc prévu un autre isolateur électrique 12 disposé entre cette électrode d'extraction 24 et la face avant de la carcasse de la source.

Cette électrode d'extraction 24 est formée d'un cône évasé vers la sortie de la source, c'est-à-dire vers le côté gauche de la figure 2. La face frontale 26 de plus petite dimension de ce cône est perforée par un orifice centré sur l'axe longitudinal 49 de la source et ayant un diamètre de 12 mm. Le demi-angle au sommet de ce cône est de l'ordre de 13°.

Sur la face évasée du cône d'extraction 24 est disposée une première électrode plane 28 perforée d'un orifice 29 disposée coaxialement avec l'orifice de perforation du cône d'extraction 24. Le diamètre de cet orifice 29 est typiquement de l'ordre de 26 mm.

A distance (de l'ordre du centimètre) de la face évasée du cône d'extraction 24 est maintenue, solidairement de celle-ci, une autre électrode plane 32, parallèle à l'électrode 28, et également perforée d'un orifice 33 disposé coaxialement avec l'orifice 29. Le cône d'extraction, et les deux électrodes planes 28 et 32 sont portés au même potentiel à savoir la masse.

Entre les deux électrodes 28 et 32 est disposée une électrode centrale plane 30 également perforée d'un orifice 31 coaxial avec les orifices 29 et 33. Alors que le diamètre de l'orifice 33 de l'électrode terminale 32 est typiquement de l'ordre de 26 mm, le diamètre de l'orifice 31 de l'électrode centrale 30 est typiquement de l'ordre de 36 mm. Cette électrode centrale est fixée par l'intermédiaire d'un isolant électrique 34 sur l'électrode terminale 32 et est portée, par l'intermédiaire d'un câble d'alimentation au contact d'un écrou 35 à une tension de polarisation choisie, typiquement 2 à 3 kV.

Les trois électrodes 28, 30 et 32 forment ici une lentille de Einzel ou, plus généralement, une optique ionique de réglage des caractéristiques géométriques du faisceau ionique extrait de la cavité. Cette optique ionique coopère avec l'électrode d'extraction 24 de la source, et l'une des fonctions de cette optique ionique de réglage est de focaliser le faisceau ionique extrait de la cavité au point focal objet de l'aimant d'analyse 7, ce qui permet au faisceau ionique de passer entièrement dans l'élément d'analyse.

Plus précisément, le cône d'extraction évasé, adapté à la forme générale du plasma dans la cavité 21 permet de canaliser celui-ci et de l'extraire sous la forme d'un faisceau dont le diamètre correspond sensiblement aux caractéristiques de l'aimant d'analyse de l'implanteur. Ainsi, alors que le diamètre usuel du faisceau ionisé extrait d'une source ECR telle que celle décrite dans EP-0527082, est de l'ordre de quelques millimètres ce qui convient aisément à des applications de séparation isotopique, le cône d'extraction de la source selon l'invention permet dans le cas présent d'obtenir un diamètre de quelques centimères ce qui est un ordre de grandeur compatible avec les caractéristiques des aimants d'analyse de la plupart des implanteurs classiques.

En outre, en raison des différences de potentiel entre l'électrode centrale de la lentille de Einzel et les deux électrodes l'entourant, le faisceau sortant du cône est tout d'abord attiré vers l'électrode centrale en convergeant vers celle-ci à travers l'orifice 29 de l'électrode 28 puis repoussé de l'électrode centrale vers la sortie de la source à travers l'orifice 33. La configuration d'une telle optique ionique de réglage dans laquelle les deux électrodes entourant l'électrode centrale sont portées au même potentiel, évite toute perte d'énergie lors du passage du faisceau à travers cette optique ionique. En outre, cette caractéristique, ainsi que la combinaison des trajets du faisceau depuis l'orifice du cône d'extraction jusqu'à la sortie de la source, permet d'obtenir un faisceau ionique de très bonne symétrie radiale. L'optique ionique de réglage permet en outre de parfaire la mise en forme du faisceau ionique, notamment en ce qui concerne son diamètre et sa focalisation, pour l'adapter parfaitement à l'aimant d'analyse en particulier en ce qui concerne son point focal objet. La mise en forme de ce faisceau ionique, c'est-à-dire notamment le réglage de la focalisation de celui-ci au point focal objet de l'élément d'analyse de l'implanteur, s'effectue en combinant le réglage de la haute tension d'alimentation de la source avec le réglage de la tension d'alimentation de l'électrode centrale de l'optique de réglage.

Généralement, les implanteurs industriels standard sont équipés en amont de l'aimant d'analyse, d'un diaphragme polarisé adapté aux caractéristiques des faisceaux d'ions extraits des sources à filament chaud classiques, et destiné à focaliser le faisceau ionique extrait de la source au point focal objet de l'aimant d'analyse. Cependant, puisque les caractéristiques géométriques d'un faisceau ionique produit par une source à filament chaud sont totalement différentes des caractéristiques géométriques d'un faisceau ionique produit par une source d'ions multichargés à résonance cyclotronique électronique, notamment au niveau du diamètre du faisceau, la simple adaptation du diaphragme polarisé existant, sur une source ECR telle que décrite dans EP 0 527 082 ne permettrait pas un fonctionnement satisfaisant de l'implanteur. En outre les diaphragmes polarisés classiques ne permettent pas une mise en forme précise du faisceau. Aussi, il est avantageusement prévu de retirer le diaphragme polarisé présent dans l'implanteur standard et de remplacer la source à filament chaud par la source ECR selon l'invention équipée de son cône d'extraction et de son optique ionique de réglage. Il convient à cette effet de noter que l'alimentation de l'optique ionique de réglage utilise les mêmes moyens que l'alimentation du diaphragme polarisé de l'implanteur classique. Une telle source ECR selon l'invention équipée de son optique de réglage permet ainsi très simplement d'adapter de tels moyens à la plupart des implanteurs industriels standard quelles que soient les caractéristiques de l'aimant d'analyse et notamment la localisation de son point focal objet.

Au niveau de l'extrémité d'entrée du tube coaxial d'injection 20 est disposée une bride 19 coopérant avec une vanne 50 d'admission du milieu gazeux dans la cavité de plasma 21. Cette vanne est du type ultra-vide selon une dénomination bien connue de l'homme du métier. En d'autres termes, elle comporte deux sièges en regard l'un de l'autre formés de matériaux métalliques différents. Une telle vanne, par exemple la vanne de fuite commercialisée par la société française RIBER sous la référence VMF-8 se distingue d'une vanne classique du type à aiguille par exemple, dans laquelle une aiguille se déplace sur un siège. En effet, alors que ce dernier type de vanne laisse entrer les gaz par bouffées rendant ainsi quasiment impossible le maintien en fonctionnement d'un vide dans la cavité de plasma inférieur à 10⁻⁶ Torr ce qui est nécessaire pour l'obtention d'ions multichargés, la vanne de type ultra-vide est un moyen permettant le maintien du vide à cette très basse valeur de pression, et notamment quelques 10^{-7.} Torr, ce qui permet l'obtention d'ions multichargés, et en particulier d'ions phosphore très fortement chargés par exemple des ions phosphores P⁴⁺ ou P⁵⁺ voire P⁶⁺. En outre, l'emploi d'une telle vanne de type ultra-vide permet de ne pas polluer l'intérieur de la cavité avec des agents polluants, par exemple de l'oxygène ou de la vapeur d'eau, lors de l'admission du milieu gazeux.

Le milieu gazeux utilisé est un milieu gazeux complexe, à savoir composé de gaz de formulation chimique complexe c'est-à-dire comportant des atomes différents de ceux destinés à produire les ions souhaités. Ainsi, on choisira avantageusement pour produire des ions phosphore, de la phosphine (PH₃) ou bien un fluorure (PF₅) ou un chlorure (PCl₅) si le pic phosphore multichargé recherché ne risque pas d'interférer du point de vue rapport masse/charge électrique avec le fluor ou le chlore présent dans la molécule. De même pour produire des ions bore, on choisira du diborane (B₂H₆), ou bien un gaz de formulation chimique BF₃ ou BCl₃ et pour produire de l'arsenic on choisira de l'arsine (A_{S}H₃) ou un gaz de formulation chimique A_{S}F₅ ou A_{S}Cl₃.

D'une façon générale on pourra utiliser les hydrures, les fluorures ou les chlorures de dopants classiques utilisés en microélectronique, et adaptés à la nature du semi-conducteur utilisé (silicium, composés III-V, II-VI), etc.).

Ces milieux gazeux complexes se distinguent donc des gaz simples, utilisables notamment dans des applications de séparation isotopique, tels que l'hydrogène, le néon, le xénon, l'argon, l'oxygène, le tungstène ou le titane.

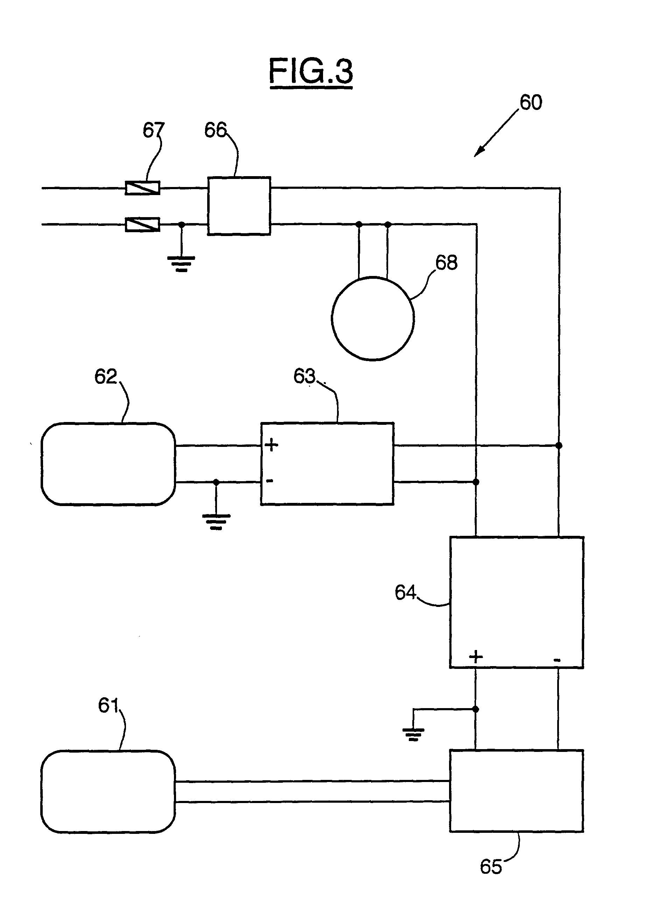

L'alimentation hyperfréquence de la source ECR 3 est illustrée schématiquement sur la figure 3. Après protection par des fusibles 67 et un filtre 66 une tension de 115 V est disponible aux bornes d'une carte d'alimentation 63 destinée à fournir une tension continue de 12 V, ainsi qu'aux bornes d'une alimentation stabilisée 64 destinée à fournir une tension de 25 V sous 5 A. Le bloc d'alimentation 63 alimente un oscillateur 62 fonctionnant au moins à 6 GHz typiquement à 10 GHz avec une puissance de 15 mW. L'alimentation stabilisée 64 alimente une carte d'alimentation 65 d'un tube à ondes progressives 61 dont la puissance minimum requise est de quelques watts et préférentiellement de 40 W. Ce tube à ondes progressives 61 est relié par l'intermédiaire d'un atténuateur variable (non représenté ici à des fins de simplification) à l'oscillateur 62. Ce tube à ondes progressives 61 amplifie donc dans le cas général un champ électromagnétique de fréquence supérieure à 6 GHz (et dans le cas présent de fréquence égale à 10 GHz) à partir d'un oscillateur hyperfréquence, par exemple le résonateur diélectrique de la société française Advantest GIGA, série "GMR FN 10R00-10F". L'utilisation d'un tube à ondes progressives, tel que celui disponible auprès de la société THOMSON CSF sous la référence TH 21738, généralement utilisé dans le domaine des radars, permet de réduire l'encombrement du générateur hyperfréquence à 40 dm³ (40 x 40 x 25 cm³) ce qui permet d'incorporer tous les composants d'alimentation hyperfréquence, illustrés sur la figure 3, et ventilés, par un ventilateur 68, dans la carcasse du bloc d'alimentation 4 d'une source d'ions, par exemple à filament chaud, classiquement disposée dans un implanteur du type illustré sur la figure 1. A cet effet, le tube de longueur voisine de 300 mm a été disposé dans la plus grande longueur de la carcasse du bloc d'alimenttion, les différentes cartes ayant été placées autour dudit tube.

La source selon l'invention équipée de son alimentation hyperfréquence peu être aisément implantée dans l'implanteur NV-3206 de la Société Américaine EATON. A l'aide d'un milieu gazeux composé de phosphine pure, il a été possible, avec une tension d'extraction de 18,6 kV (pour un maximum disponible de 20 kV) et un réglage adéquat de la lentille de Einzel (2,8 kV), d'obtenir au niveau de la plaquette à implanter, un courant de phosphore de 24,2 µA pour des ions P⁺, de 37,8 µA pour des ions P²⁺, de 48,9 µA pour des ions P³⁺, de 44,3 µA pour des ions P⁴⁺, de 34 µA pour des ions P⁵⁺ et de 6,1 µA pour des ions P⁶⁺. Il convient de noter que l'utilisation de la vanne de type ultra-vide permet d'obtenir un vide en marche de 2,4 10⁻⁷ Torr alors que le vide de base dans la source (hors fonctionnement) est de 2,1 10⁻⁷ Torr.

Le profil des atomes d'oxygène (issus par exemple de la vapeur d'eau (vide non parfait)) et de fluor (dans le cas d'utilisation de fluorure) montre que les pics P⁴⁺, dont le rapport masse/charge est de l'ordre de 7,75, et P⁵⁺, dont le rapport masse/charge. est de l'ordre 6,2, ne sont pas perturbés par les pics parasites respectifs des atomes d'oxygène O²⁺ et fluor F³⁺. Les différentes modifications internes du terminal haute tension de l'implanteur ont permis la transformation de cet implanteur ayant une énergie initiale d'implantation de 200 à 250 keV en une machine d'implantation à haute énergie (1 MeV pour les ions P⁴⁺ ou même 1,5 MeV pour les ions P⁶⁺). Il a été ainsi possible d'implanter des doses de 10¹⁴ ions par cm² à 2, 3, 4, 5 ou 6 fois l'énergie maximale de l'implanteur et ceci en un temps compatible avec les exigences de production (une dose de10¹⁴ obtenue en deux minutes pour une plaque d'une diamètre de 100 mm). Enfin ces conditions de fonctionnement qui ne nécessitent pas une utilisation de filament chaud, ni de pièces en mouvement, ni de basse pression dans la chambre du plasma augmentent considérablement la durée de vie de la source par rapport à celle des sources à filament chaud.

## Revendications

1. Implanteur ionique haute énergie du type faible ou moyen courant, comportant une source d'ions multichargés à résonance cyclotronique électronique (3) avec une cavité de plasma (21) formant guide d'ondes capable de recevoir un milieu gazeux complexe compatible avec le faisceau ionisé généré, et un générateur hyperfréquence (60) à tube à ondes progressives (61) couplé à ladite source et générant un champ électromagnétique de fréquence supérieure ou égale à 6 GHz, la cavité de plasma (21) ayant une dimension caractéristique (D), dans le plan transversal de la cavité, du même ordre de grandeur que la longueur d'onde du champ électromagnétique, la source étant munie au niveau de son extrémité d'entrée de moyens d'admission du milieu gazeux permettant le maintien d'une pression résiduelle en fonctionnement inférieure à un seuil de pression compatible avec l'obtention d'ions multichargés,
**caractérisé par le fait que** la source (3) est munie au niveau de son extrémité de sortie d'une optique ionique de réglage (28, 30, 32) des caractéristiques géométriques du faisceau de plasma ionisé extrait de la cavité, ladite optique ionique étant commandable et coopérant avec l'électrode d'extraction (24) de la source d'ions formée d'un cône s'évasant vers la sortie de la source.

2. Implanteur selon la revendication 1, **caractérisé par le fait que** le seuil de pression est égal à environ 10⁻⁶ Torr.

3. Implanteur selon la revendication 2, **caractérisé par le fait que** la pression résiduelle en fonctionnement est de quelques 10⁻⁷ Torr en fonctionnement.

4. Implanteur selon l'une des revendications précédentes, **caractérisé par le fait que** le milieu gazeux complexe est choisi dans le groupe formé par les hydrures, les fluorures, les chlorures des dopants compatibles avec la nature d'un matériau semi-conducteur à implanter.

5. Implanteur selon l'une des revendications précédentes, **caractérisé par le fait que** l'optique ionique de réglage comporte une première électrode plane perforée (28) disposée sur la face évasée du cône d'extraction (24), une deuxième électrode plane perforée, espacée de la première, et portée au même potentiel que celui du cône d'extraction (24) et de la première électrode (28), et une électrode centrale (30) plane et perforée, disposée entre les première et deuxième électrodes (28, 32), et polarisée par rapport aux deux électrodes par une tension de polarisation réglable.

6. Implanteur selon l'une des revendications précédentes, **caractérisé par le fait que** l'optique ionique est fixée à la source par un premier isolateur électrique (12) tandis que la source est solidaire d'une bride de fixation (22) équipée d'un deuxième isolateur électrique (16), ladite bride de fixation étant destinée à être fixée par l'intermédiaire de ce deuxième isolateur électrique, sur l'implanteur ionique (40).

7. Implanteur selon la revendication 6, **caractérisé par le fait que** la dimension caractéristique de la cavité est de l'ordre de 3 cm et **par le fait que** la bride de fixation sur l'implanteur a un diamètre extérieur est de l'ordre de 40 cm.

8. Implanteur selon l'une des revendications précédentes, **caractérisé par le fait que** le générateur hyperfréquence forme un module d'alimentation hyperfréquence (60) séparé de la source équipée de sa bride de fixation et de l'optique ionique de réglage, le module d'alimentation ayant un volume utile inférieur à 50 dm³, et comportant le tube à ondes progressives (61) relié à un oscillateur (62) par l'intermédiaire d'un atténuateur variable, ainsi que les blocs d'alimentation des éléments, et **par le fait que** le module d'alimentation hyperfréquence est couplé à la cavité de plasma de la source par un guide d'ondes.

9. Implanteur selon l'une des revendications précédentes, **caractérisé par le fait que** les moyens d'admission du milieu gazeux complexe comportent une vanne d'admission du type ultra-vide (50).

10. Implanteur selon l'une des revendications précédentes, **caractérisé par le fait que** la fréquence du champ électromagnétique générée par le générateur hyperfréquence est de l'ordre de 10 GHz, et **par le fait que** la puissance du tube à onde progressive est de l'ordre de 40 W.

11. Procédé d'utilisation d'un implanteur tel que défini dans l'une des revendications 1 à 10, **caractérisé par le fait qu'**on admet dans la cavité de plasma le milieu gazeux complexe compatible avec le faisceau d'ions souhaités, on règle le débit d'admission du milieu gazeux de façon à maintenir dans la cavité de plasma un vide résiduel inférieur audit seuil de pression, et on règle la focalisation du faisceau ionique extrait de la cavité de plasma, au point focal de l'aimant d'analyse (7) de l'implanteur.

12. Procédé selon la revendication 11, **caractérisé par le fait qu'**on règle la focalisation du faisceau ionique extrait de la cavité de plasma au point focal objet de l'aimant d'analyse de l'implanteur en réglant la tension d'alimentation de l'optique ionique de réglage de la source.

## Patentansprüche

1. Schwach- oder Mittelstromhochenergieionimplantationsvorrichtung, welche eine elektronische Zyklotronresonanzquelle (3) mehrfach geladener Ionen mit einem Plasmahohlraum (21) der einen Wellenleiter bildet, in dem eine Gaskomplexumgebung aufgenommen sein kann, die mit dem erzeugten Ionenstrahl kompatibel ist, und einen Ultrahochfrequenzgenerator (60) mit Lauffeldröhre (61) umfaßt, die mit der besagten Quelle verbunden ist und ein elektromagnetisches Feld mit einer Frequenz über oder gleich 6 GHz erzeugt, welcher Plasmahohlraum (21) eine charakteristische Abmessung D in der Querebene des Hohlraumes in der gleichen Größenordnung wie die Wellenlänge des elektromagnetischen Feldes hat, welche Quelle auf der Höhe ihres Eingangsendes mit Einrichtungen zum Zutritt der Gasumgebung versehen ist, die es erlauben, diese unter einem Restarbeitsdruck zu halten, der unter einem Druckschwellenwert liegt, der mit der Erzielung von mehrfach geladenen Ionen kompatibel ist,
**dadurch gekennzeichnet, daß** die Quelle (3) auf der Höhe ihres Ausgangsendes mit einer Ionenoptik (28, 30, 32) zum Regeln der charakteristischen Geometrie des ionisierten Plasmastrahl versehen ist, der den Hohlraum verläßt, welche Ionenoptik steuerbar ist und mit der Extraktionselektrode (24) der Ionenquelle zusammenarbeitet, die aus einem Konus besteht, der sich zum Ausgang der Quelle erweitert.

2. Implantationsvorrichtung nach Anspruch 1, **dadurch gekennzeichnet, daß** der Druckschwellenwert bei etwa 10⁻⁶ Torr liegt.

3. Implantationsvorrichtung nach Anspruch 2, **dadurch gekennzeichnet, daß** der Restarbeitsdruck im Betrieb bei einigen 10⁻⁷ Torr liegt.

4. Implantationsvorrichtung nach einem der vorhergehenden Ansprüche, **dadurch gekennzeichnet, daß** die Gaskomplexumgebung aus einer Gruppe gewählt ist, die aus Hydriden, Fluoriden und Chloriden von Dotierstoffen besteht, die mit der Art des zu implantierenden Halbleitermaterials kompatibel sind.

5. Implantationsvorrichtung nach einem der vorhergehenden Ansprüche, **dadurch gekennzeichnet, daß** die Ionenoptik zum Regeln eine erste ebene perforierte Elektrode (28), die an der sich erweiternden Fläche des Extraktionskonus (24) angeordnet ist, eine zweite perforierte Elektrode im Abstand von der ersten Elektrode, die auf demselben Potential wie der Extraktionskonus (24) liegt, und eine ebene perforierte zentrale Elektrode (30) umfaßt, die zwischen der ersten und der zweiten Elektrode (28, 32) angeordnet ist und bezüglich der beiden Elektroden durch eine regelbare Vorspannung vorgespannt ist.

6. Implantationsvorrichtung nach einem der vorhergehenden Ansprüche, **dadurch gekennzeichnet, daß** die Ionenoptik an der Quelle über einen ersten elektrischen Isolator (12) befestigt ist, während die Quelle an einer Befestigungsschelle (22) fest angebracht ist, die mit einem zweiten elektrischen Isolator (16) versehen ist, welche Befestigungsschelle dazu bestimmt ist, über den zweiten elektrischen Isolator an der Ionenimplantationsvorrichtung (40) befestigt zu werden.

7. Implantationsvorrichtung nach Anspruch 6, **dadurch gekennzeichnet, daß** die charakteristische Abmessung des Hohlraumes in der Größenordnung von 3 cm liegt und daß die Befestigungsschelle an der Implantationsvorrichtung einen Außendurchmesser in der Größenordnung von 40 cm hat.

8. Implantationsvorrichtung nach einem der vorhergehenden Ansprüche, **dadurch gekennzeichnet, daß** der Ultrahochfrequenzgenerator einen Ultrahochfrequenzquellenmodul (60) bildet, der von der mit der Befestigungsschelle und der Ionenregeloptik versehenen Quelle getrennt ist, welcher Quellenmodul ein Nutzvolumen von weniger als 5 dm3 hat und die Lauffeldröhre (61) umfaßt, die mit einem Oszillator (62) über ein variables Dämpfungsglied sowie Versorgungsblöcke für diese Elemente verbunden ist, und daß der Ultrahochfrequenzquellenmodul mit dem Plasmahohlraum der Quelle über Wellenleiter verbunden ist.

9. Implantationsvorrichtung nach einem der vorhergehenden Ansprüche, **dadurch gekennzeichnet, daß** die Einrichtungen zum Zutritt der Gaskomplexumgebung ein Ultrahochvakuumzutrittsventil (50) umfassen.

10. Implantationsvorrichtung nach einem der vorhergehenden Ansprüche, **dadurch gekennzeichnet, daß** die Frequenz des elektromagnetischen Feldes, das vom Ultrahochfrequenzgenerator erzeugt wird, in der Größenordnung von 10 GHz liegt und daß die Leistung der Lauffeldröhre in der Größenordnung von 40 W liegt.

11. Verfahren zum Verwenden einer Implantationsvorrichtung nach einem der Ansprüche 1 bis 10, **dadurch gekennzeichnet, daß** man in den Plasmahohlraum eine Gaskomplexumgebung einführt, die mit den gewünschten Ionenstrahlen kompatibel ist, daß man die Zutrittsmenge der Gasumgebung so regelt, daß im Hohlraum ein Restunterdruck beibehalten wird, der unter dem besagten Druckschwellenwert liegt, und daß man die Fokussierung des Ionenstrahls, der den Plasmahohlraum verläßt, auf den Brennpunkt des Analysemagneten (7) der Implantationsvorrichtung regelt.

12. Verfahren nach Anspruch 11, **dadurch gekennzeichnet, daß** man die Fokussierung des Ionenstrahles, der den Plasmahohlraum verläßt, auf den Zielbrennpunkt des Analysemagneten der Implantationsvorrichtung dadurch regelt, daß man die Versorgungsspannung der Ionenregeloptik der Quelle regelt.

## Claims

1. A high-energy ion implanter of the low- or medium-current type, comprising an electron cyclotron resonance multiply-charged ion source (3) with a waveguide-forming plasma cavity (21) which is capable of receiving a complex gaseous medium compatible with the ion beam generated, and a microwave generator (60) having a traveling-wave tube (61) coupled to said source and generating an electromagnetic field with a frequency greater than or equal to 6 GHz, the plasma cavity (21) having a characteristic dimension (D), in the transverse plane of the cavity, of the same order of magnitude as the wavelength of the electromagnetic field, the source being provided at its output end with means for admitting the gaseous medium, making it possible to maintain a residual pressure in operation below a pressure threshold compatible with obtaining multiply-charged ions,
**characterized in that** the source (3) is provided at its output end with an ion optics system (28, 30, 32) for adjusting the geometrical characteristics of the ionized plasma beam extracted from the cavity, said ion optics system being controllable and interacting with the extraction electrode (24) of the ion source, formed by a cone which flares out toward the output of the source.

2. The implanter as claimed in claim 1,
**characterized in that** the pressure threshold is equal to approximately 10⁻⁶ torr.

3. The implanter as claimed in claim 2, **characterized in that** the residual pressure in operation is a few 10⁻⁷ torr in operation.

4. The implanter as claimed in one of the preceding claims, **characterized in that** the complex gaseous medium is chosen from the group formed by the hydrides, fluorides and chlorides of the dopants compatible with the nature of a semiconductor material to be implanted.

5. The implanter as claimed in one of the preceding claims, **characterized in that** the ion adjustment optics system includes a first drilled plane electrode (28) arranged on the flared face of the extraction cone (24), a second drilled plane electrode, spaced away from the first one and at the same potential as that of the extraction cone (24) and of the first electrode (28), and a plane and drilled central electrode (30) which is arranged between the first and second electrodes (28, 32) and biased with respect to the two electrodes by an adjustable bias voltage.

6. The implanter as claimed in one of the preceding claims, **characterized in that** the ion optics system is fastened to the source by a first electrical isolator (12) while the source is secured to a fastening flange (22) equipped with a second electrical isolator (16), said fastening flange being intended to be fastened via this second electrical isolator to the ion implanter (40).

7. The implanter as claimed in claim 6, **characterized in that** the characteristic dimension of the cavity is of the order of 3 cm and **in that** the flange for fastening to the implanter has an external diameter of the order of 40 cm.

8. The implanter as claimed in one of the preceding claims, **characterized in that** the microwave generator forms a microwave supply module (60) separated from the source equipped with its fastening flange and with its ion adjustment optics system, the supply module having a working volume of less than 50 dm³ and including the traveling-wave tube (61) connected to an oscillator (62) via a variable attenuator, as well as the power-supply units for the elements, and **in that** the microwave supply module is coupled to the plasma cavity of the source via a waveguide.

9. The implanter as claimed in one of the preceding claims, **characterized in that** the means for admitting the complex gaseous medium include an inlet valve (50) of the ultravacuum type.

10. The implanter as claimed in one of the preceding claims, **characterized in that** the frequency of the electromagnetic field, generated by the microwave generator, is of the order of 10 GHz and **in that** the power of the traveling-wave tube is of the order of 40 W.

11. A method of using an implanter as defined in one of claims 1 to 10, **characterized in that** the complex gaseous medium, compatible with the beam of ions desired, is admitted into the plasma cavity, the inlet flow rate of the gaseous medium is adjusted so as to maintain a residual vacuum in the plasma cavity which is less than said pressure threshold, and the focusing of the ion beam extracted from the plasma cavity is adjusted onto the focal point of the scanning magnet (7) of the implanter.

12. The method as claimed in claim 11, **characterized in that** the focusing of the ion beam extracted from the plasma cavity is adjusted onto the object focal point of the scanning magnet of the implanter by adjusting the supply voltage of the ion optics system for adjusting the source.
